# FASCICULE DE BREVET EUROPEEN

(11) **EP 1 254 081 B1**
(45) Date de publication et mention de la délivrance du brevet: **03.01.2007**
(21) Numéro de dépôt: 01907720.5
(22) Date de dépôt: 07.02.2001
(51) Int. Cl.: C03C 17/00

(54) **PROCEDE POUR LE TRANSPORT DE VITRAGES A TRAVERS UNE INSTALLATION DE DEPOT DE REVETEMENT, ET DISPOSITIF DE TRANSPORT POUR LESDITS VITRAGES**
TRANSPORTVERFAHREN FÜR SCHEIBEN DURCH EINE BESCHICHTUNGSANLAGE UND IHRE TRANSPORTVORRICHTUNG
METHOD FOR TRANSPORTING GLASS PANELS THROUGH A COATING INSTALLATION AND DEVICE FOR TRANSPORTING SAID GLASS PANELS

(30) Priorité: 11.02.2000 DE 10006121
(43) Date de publication de la demande: 06.11.2002
(73) Titulaire: SAINT-GOBAIN GLASS FRANCE, 92400 Courbevoie (FR)
(72) Inventeur: KOOPMANN, Dirk, 41564 Kaarst (DE); CRUMBACH, Richard, 52072 Aachen (DE); KRAMLING, Franz, 52072 Aachen (DE); HOULENA, Michael, 52223 Stolberg (DE)
(74) Mandataire: Muller, René
(86) Numéro de dépôt international: PCT/FR2001/000354
(87) Numéro de publication internationale: WO 2001/058818

(56) Documents cités:
- EP-A- 0 570 260
- EP-A- 0 839 769
- DATABASE WPI Section Ch, Week 198907 Derwent Publications Ltd., London, GB; Class A88, AN 1989-051915 XP002169023 -& JP 64 003035 A (CENTRAL GLASS CO LTD), 6 janvier 1989 (1989-01-06)
- DATABASE WPI Section Ch, Week 199141 Derwent Publications Ltd., London, GB; Class L01, AN 1991-299625 XP002169024 -& JP 03 199141 A (AISIN SEIKI KK), 30 août 1991 (1991-08-30)

## Description

L'invention se rapporte à un procédé pour le transport de vitrages, en particulier de vitrages bombés, à munir d'un revêtement, présentant les caractéristiques du préambule de la revendication 1 ainsi qu'à un dispositif de transport convenant pour sa mise en oeuvre, suivant la revendication indépendante 8.

On comprend par "vitrage" tout substrat en verre ou association de substrats comprenant au moins un substrat en verre. On comprend par revêtement une ou plusieurs couches minces (épaisseurs généralement comprises entre 0.5 et 300 nm pour chacune des couches), du type couche métallique (argent), et/ou couches en diélectriques (du type oxyde métallique, nitrure de silicium ..).

Pour le revêtement de vitrages, en particulier de vitrages bombés, avec des couches minces suivant le procédé de pulvérisation cathodique assistée par champ magnétique - désigné dans la suite par le terme "pulvérisation" - les vitrages posés sur des dispositifs de support sont transportés à travers l'installation dans des dispositifs connus à fonctionnement continu. Inévitablement, des particules arrachées à la cathode se déposent sur toutes les surfaces et sur tous les objets se trouvant dans la chambre sous vide considérée.

En règle générale, la couche déposée par pulvérisation - ou un ensemble de plusieurs couches produites les unes après les autres - ne doit être déposée que sur une des faces des vitrages. On doit dès lors empêcher que des particules de revêtement ne se déposent aussi sur l'autre face (face "arrière"), celle qui ne doit pas être revêtue, afin d'éviter des traitements post-dépôt comme l'enlèvement de particules de revêtement sur la face en question devant rester dépourvue de revêtement.

Dans le cas de vitrages plans, il est simple de couvrir les faces qui ne doivent pas être munies de revêtement : on transporte ceux-ci sur un transporteur plan à travers les chambres de pulvérisation, le cas échéant sur un autre vitrage plan servant de support intermédiaire. Lors du dépôt du revêtement, on a également déjà essayé d'utiliser des vitrages de même courbure comme supports intermédiaires. Cette façon de procéder n'est pas toujours applicable, parce que d'une part les vitrages doivent rester immobiles pendant l'opération de revêtement, et parce que d'autre part la face tournée vers le transporteur n'est pas entièrement couverte.

On peut aussi poser les vitrages bombés sur un dispositif de transport à caissons, qui ne supporte les vitrages que le long de leur bord - exactement comme des formes de cadre de bombage connues -, de telle façon que leur face arrière soit masquée et forme quasiment une portion de la paroi intérieure du caisson. Un inconvénient de ce type de support est cependant qu'il doit être très spécifiquement adapté au contour du modèle de vitrage en question. En particulier, le bord du support doit suivre exactement le contour courbe du bord du vitrage. Dans les vitrages pour véhicules précisément, il existe cependant un nombre incalculable de modèles de vitrages pour chaque type de vitrage (parebrise, lunette arrière, toit-auto, custode ...), avec à chaque fois des contours et des courbures différentes, de sorte que l'on devrait stocker et utiliser en plusieurs exemplaires un nombre élevé de supports individuels.

Actuellement, la demande de vitrages bombés revêtus est encore relativement faible, de sorte que l'on peut ne produire qu'un nombre relativement réduit de chaque modèle de vitrage. Un fréquent changement de modèle, inévitable dans de telles petites séries, pour une production industrielle de revêtements, est cependant compliqué et coûteux avec les supports et les dispositifs de transport actuels. En particulier, l'installation de revêtement doit être fréquemment arrêtée, et donc le flux de production interrompu.

Les vitrages revêtus sont en règle générale incorporés ensuite dans des vitrages feuilletés, dans lesquels leur face non revêtue est orientée vers l'extérieur. La surface du vitrage revêtue est recouverte et protégée par la couche suivante du composite (les vitrages feuilletés ont le plus souvent la structure verre/ revêtement éventuel/ feuille thermoplastique du type PVB/verre).

Le document Database WPI Section Ch, Week 198907 Derwent Publication Ltd., London, GB ; Class A88, AN 1989-051915, JP 64003035, enseigne le dépôt de couches sur une feuille de verre horizontale dont le bord est encapsulé dans un matériau souple, ladite feuille ainsi encapsulée reposant sur quatre bandes de matériau croisées fixées sur un cadre. Un film peut ainsi être réalisé sur une seule face, bords exclus.

Il est connu du brevet DE 196 43 935 C2, lors du bombage de vitrages en position horizontale, d'utiliser dans au moins deux stations de bombage successives des dispositifs de transport qui présentent un tissu porteur disposé souplement sur un cadre porteur rigide. Les vitrages posés sur ce tissu porteur sont transportés pas à pas à travers l'installation de bombage, et sont déformés en contact avec le tissu. On utilise de préférence des tissus usuels du commerce, composés de fibres métalliques résistant à la chaleur, qui sont également utilisés dans d'autres domaines, notamment en tant que garniture de moules de bombage superficiels et annulaires. Ce procédé a pour but d'éviter des mouvements relatifs des vitrages chauffés à la température de ramollissement par rapport au dispositif de transport, ainsi que de soutenir les vitrages sur toute leur surface pendant le transport. On évite ainsi des détériorations de surface et des déformations indésirables.

L'invention a pour objet de proposer un procédé pour le transport de vitrages à travers une installation de revêtement, qui permette une utilisation plus souple de l'installation pour des formes, des tailles et des courbures de vitrages différents, en particulier des vitrages bombés, sans dépenses excessives, ainsi qu'un dispositif de transport adéquat pour la mise en oeuvre de ce procédé.

Conformément à l'invention, cet objectif est atteint, en ce qui concerne le procédé, par les caractéristiques de la revendication 1. Les caractéristiques de la revendication indépendante 8 concernent un dispositif correspondant. Les caractéristiques des revendications dépendantes concernent des variantes avantageuses de ce procédé et de ce dispositif selon l'invention.

Des essais ont montré qu'un transport des vitrages à revêtir en contact de la face avec un tissu approprié (plat et souple de préférence) suffisamment imperméable était possible, et conduisait au résultat désiré, à savoir qu'aucune particule de revêtement ne se déposait sur la face tournée vers le tissu. L'utilisation d'un sur-revêtement, dit "overspray", peut ainsi être évité. En outre, le tissu peut aussi empêcher le dépôt de particules de revêtement sur d'autres parties de l'installation de revêtement, elles-aussi recouvertes par le tissu.

En guise de tissus utilisables pour cette application, on a expérimenté des tissus métalliques du commerce. Des résultats positifs ont été obtenus avec des tissus de la firme Paul, Metallgewebe - Filterfabrik (Undustriegebiet West - D-36396 Steinau an der Strasse), décrits dans le tableau ci-dessous. Ces indications ne sont cependant données qu'à titre d'exemples et ne limitent pas la portée de l'invention.

| | |
|---|---|
| Matériau 1.4401 | Matériau 1.4301 |
| Tissu n° 38 | Tissu n ° 48 |
| Mode de tissage: lisse | Mode de tissage: tissage lin |
| Diamètre de fil: 0,165 mm | Diamètre de fil: 0,130 mm |
| Maille µm: 503 | Maille µm: 400 |

Le procédé de transport n'est pas non plus limité à une utilisation dans le cadre du procédé de pulvérisation mentionné dans l'introduction du présent texte.

La position dans laquelle les vitrages sont transportés sur le tissu à travers l'installation de revêtement est en principe sans importance, dans la mesure où un contact de surface est assuré entre le tissu et la face des vitrages. Ceci peut se produire par l'action de la gravité, quand les vitrages sont en position horizontale, ou en position légèrement inclinée par rapport à l'horizontal sur le tissu.

Le contact de surface tissu/verre peut aussi être assuré ou facilité par des dispositifs adéquats de maintien ou de tension, avec lesquels le vitrage est pressé contre la face souple de tissu. Ceci est indispensable lorsque les vitrages sont transportés sur chant à travers l'installation de revêtement, ou même en suspension, c'est-à-dire quand les particules de revêtement sont projetées en direction des vitrages contre la force de gravité. Dans le dernier cas, le tissu repose sur la face à ne pas recouvrir du vitrage. Les vitrages sont fixés à leur périphérie par des attaches appropriées.

Dans de nombreux cas, le revêtement est distant du bord des vitrages (en retrait par rapport au chant du ou des verres du vitrage), ceci pour éviter la corrosion du revêtement (notamment quand il contient au moins une couche d'argent) démarrant à partir du bord du vitrage feuilleté. En particulier, le vitrage peut être conçu, par exemple, pour permettre un collage périphérique sûr du verre revêtu dans le feuilleté ou par exemple avec un cadre - par exemple un encadrement de pare-brise - ou avec un intercalaire dans le cas d'un vitrage isolant. On peut même, dès lors, accrocher mécaniquement lesdits dispositifs de maintien ou de tension sur la face à revêtir des vitrages, dans la mesure où ceux-ci n'empiètent pas sur la face du vitrage au-delà de la zone à maintenir dépourvue de revêtement.

Lorsqu'il est possible, dans l'installation, de déterminer le contour périphérique des vitrages déposés, on peut, selon le type de ces dispositifs de maintien ou de tension, prévoir leur positionnement automatique sur le bord des vitrages, ce qui évite (ou au moins réduit) une dépense de transformation à cet égard.

Etant donné que ces tissus à petites mailles opposent relativement peu de résistance au passage de l'air en direction normale, les vitrages peuvent en principe être également aspirés par des ventouses, par l'arrière du tissu, contre la face de tissu. Une certaine tension peut être ainsi conférée au tissu. Ceci peut être réalisé en déposant d'abord le vitrage sur la face de tissu, en appliquant ensuite les ventouses et en amorçant la dépression d'air, et enfin en ramenant les ventouses légèrement en retrait, selon une distance prédéterminée par rapport au vitrage qu'elles maintiennent. Par rapport à des dispositifs de tension mécaniques accrochés au bord du vitrage, de telles ventouses présentent l'avantage de ne pas devoir être positionnées d'une manière aussi exacte.

Dans une station de revêtement opérant sous vide, les ventouses ne peuvent cependant plus appliquer aucune force de maintien. Leur utilisation est toutefois également possible ici, pour assurer dans chaque cas un bon contact de surface lors de la pose des vitrages sur le tissu. Lorsque le tissu présente une certaine déformabilité quasiment plastique, le contour de chaque vitrage bombé déposé peut s'imprimer dans le tissu.

Il va de soi en outre qu'en cas de besoin, on peut munir le dispositif de transport portant le tissu de dispositifs de tension, qui empêchent un fléchissement de la face de tissu chargée du vitrage. En même temps, leur force de tension doit être suffisamment faible - en tous cas pour un support purement par gravité - pour permettre le contact de surface entre le vitrage et le tissu.

Notamment au cas où la face de tissu fait partie d'un caisson ou d'un cadre avec des côtés fermés et si une pénétration de particules de revêtement par les côtés est ainsi exclue, on peut prévoir avantageusement une découpe dans le tissu, afin d'améliorer l'adaptation ou la conformation de la surface du tissu à la surface du vitrage.

D'une part, il est préférable que cette découpe soit entièrement recouverte par le plus petit vitrage à transporter. En fait, dans certains cas, la découpe peut être presque aussi grande que la surface du verre, en tout cas représenter au moins 50 à 70% de la surface du verre, avec laquelle le tissu est en contact.

D'autre part, la face et le pourtour du caisson ou du cadre doivent de préférence être plus grands que la face et le pourtour du plus grand vitrage à transporter. Pour d'autres informations nécessaires pour réaliser de tels dispositifs de transport, on peut se reporter par exemple au document DE 196 43 935 C2 déjà cité. Le tissu étant imperméable, on peut éviter des dépôts indésirables de particules sur la face arrière du vitrage, également dans la zone de ladite découpe. (On entend par "imperméable" le fait que le tissu ne laisse pas passer les particules qui peuvent être émises par les cibles de pulvérisation, mais le tissu peut être perméable aux gaz, tout particulièrement à l'air.)

Bien entendu, des particules de revêtement vont aussi se déposer sur le tissu lui-même et y adhérer. Un nettoyage périodique des faces de tissu par des moyens appropriés (soufflage, secouage, etc) est dès lors utile, afin que de la matière de revêtement ne soit pas transférée de façon indésirable de la face de tissu sur la face arrière des vitrages. De même, il est préférable de changer les tissus périodiquement. Le temps nécessaire pour ces travaux d'entretien est cependant nettement moindre que le temps qu'il faudrait consacrer à l'échange des masques spécifiques aux vitrages dans des installations conventionnelles, sans support à l'aide de tissu.

La taille des dispositifs de transport est d'une part limitée par les sections transversales disponibles dans l'installation de revêtement. D'autre part, on peut déposer plusieurs vitrages différemment profilés et/ou bombés, les uns à côté des autres, sur les faces du tissu, tant qu'il y a contact entre le verre de la face arrière des vitrages et le tissu (éventuellement découpé comme évoqué plus haut), de telle façon que l'on puisse atteindre un rendement de production élevé, en particulier avec des vitrages de surface relativement petite et/ou pour de grandes sections transversales dans l'installation de dépôt du revêtement.

## Revendications

1. Procédé pour le transport de vitrages, en particulier de vitrages bombés, à munir d'un revêtement, à travers une installation de revêtement, dans lequel les vitrages sont transportés au moyen d'un dispositif de transport à travers l'installation, d'une façon telle qu'une de leurs faces principales soit au moins en partie recouverte d'une protection contre la matière de revêtement à appliquer, **caractérisé en ce que**, pendant l'opération du dépôt du revêtement, au moins une partie de la face des vitrages à protéger est maintenue en contact avec un tissu souple, attaché au dispositif de transport et empêchant le dépôt de matière de revêtement.

2. Procédé suivant la revendication 1, **caractérisé en ce que** le tissu est pourvu, pour augmenter sa souplesse, d'une découpe dont le contour est de préférence plus petit que le contour du plus petit vitrage fixe à transporter.

3. Procédé suivant la revendication 1 ou 2, **caractérisé en ce que** le contact entre les vitrages et la face de tissu est amélioré par des moyens additionnels, afin d'assurer une application sur toute la surface.

4. Procédé suivant la revendication 3, **caractérisé en ce que** le contact des vitrages avec le tissu est amélioré au moyen de dispositifs de tension mécaniques accrochés au bord extérieur des vitrages.

5. Procédé suivant la revendication 3, **caractérisé en ce que** le contact des vitrages avec le tissu est amélioré par une application locale d'une dépression par l'arrière de la face de tissu.

6. Procédé suivant l'une quelconque des revendications précédentes, **caractérisé en ce que** l'on transporte les vitrages posés sur une face de tissu souple librement tendue.

7. Procédé suivant l'une quelconque des revendications 3 à 5, **caractérisé en ce que** l'on transporte les vitrages en position dressée.

8. Procédé pour munir des vitrages d'un revêtement, lesdits vitrages étant transportés à travers une installation de revêtement par le procédé de l'une des revendications précédentes.

9. Installation de dépôt d'un revêtement sur l'une des faces de vitrages comprenant un dispositif de transport pour le transport des vitrages à travers l'installation de dépôt, ledit dispositif comprenant des moyens pour recouvrir au moins une partie de l'autre face desdits vitrages, afin d'éviter le dépôt de matière de revêtement sur ladite autre face, le moyen de recouvrement comprenant un tissu souple, qui est attaché au dispositif de transport d'une façon telle que ladite autre face est au moins partiellement en contact avec ledit tissu pendant l'opération de dépôt du revêtement.

10. Installation selon la revendication précédente, **caractérisée en ce qu'**il est prévu des moyens pour tendre la face de tissu.

11. Installation selon l'une des deux revendications précédentes, **caractérisée en ce que** le tissu est tendu au-dessus d'un caisson ou d'un cadre, dont la surface est de préférence plus grande que la surface du plus grand vitrage à transporter.

12. Installation selon l'une des revendications précédentes d'installation, **caractérisée en ce que** le tissu est pourvu d'une découpe, dont le contour est de préférence plus petit que le contour du plus petit vitrage à transporter.

13. Installation selon l'une des revendications précédentes d'installation, **caractérisée en ce que** le dispositif de transport comprend des moyens pour améliorer le contact de surface entre la surface du vitrage à recouvrir et la surface de tissu.

14. installation selon la revendication précédente, **caractérisé en ce que** les moyens sont des dispositifs de tension mécaniques accrochés au bord extérieur des vitrages.

15. Installation selon la revendication précédente 13, **caractérisé en ce que** les moyens sont des ventouses agissant par l'arrière de la face de tissu.

16. Procédé pour munir des vitrages d'un revêtement, lesdits vitrages étant transportés à travers l'installation de l'une des revendications précédentes d'installation.

## Claims

1. Method for transporting glazing, particularly curved glazing, that is to be coated, through a coating plant, in which method the glazing is transported by means of a transport device through the plant, in such a way that one of its main sides is at least partially covered with a protection against the coating substance that is to be applied, **characterized in that** during the coating-depositing operation, at least part of the side of the glazing that is to be protected is kept in contact with a flexible fabric attached to the transport device and preventing the deposition of coating substance.

2. Method according to Claim 1, **characterized in that** the fabric is equipped, in order to increase its flexibility, with a cut, the outline of which is preferably smaller than the outline of the smallest piece of fixed glazing that is to be transported.

3. Method according to Claim 1 or 2, **characterized in that** contact between the glazing and the face of the fabric is improved by additional means, so as to ensure application across the entire surface.

4. Method according to Claim 3, **characterized in that** contact between the glazing and the fabric is improved by means of mechanical tensioning devices hooked to the outer edge of the glazing.

5. Method according to Claim 3, **characterized in that** contact between the glazing and the fabric is improved by local application of a partial vacuum from the rear of the face of the fabric.

6. Method according to any one of the preceding claims, **characterized in that** the glazing is transported placed on a slightly tensioned face of flexible fabric.

7. Method according to any one of claims 3 to 5, **characterized in that** the glazing is transported in the upright position.

8. Method for coating glazing, said glazing being transported through a coating device with the method according to one of the preceeding claims.

9. Device for coating one of the sides of the glazing comprising a transport device for transporting the glazing through a plant for depositing a coating on one of the sides of the glazing, the said device comprising means for covering at least part of the other side of the said glazing so as to prevent coating substance from being deposited on the said other side, **characterized in that** the covering means comprises a flexible fabric which is attached to the transport device in such a way that the said other side is at least partially in contact with the said fabric during the coating-depositing operation.

10. Device according to preceeding claim, **characterized in that** means are provided for tensioning the face of the fabric.

11. Device according to one of the two preceeding claims, **characterized in that** the fabric is tensioned over a box or a frame, the surface of which is preferably larger than the surface of the largest piece of glazing that is to be transported.

12. Device according to one of the preceeding device claims, **characterized in that** the fabric has a cut-out, the outline of which is preferably smaller than the outline of the smallest piece of glazing that is to be transported.

13. Device according to one of the preceeding device claims, **characterized in that** the transport device comprises means for improving the surface contact between the surface of the glazing that is to be covered and the surface of the fabric.

14. Device according to preceeding claim, **characterized in that** the means are mechanical tensioning devices hooked to the outer edge of the glazing.

15. Device according to Claim 13, **characterized in that** the means are suction cups acting from the rear of the face of the fabric.

16. Process for coating glazing, said glazing being transported through the device according to one of the preceeding device claims.

## Patentansprüche

1. Verfahren zum Transportieren von mit einer Beschichtung zu versehenden Glasscheiben, insbesondere von gebogenen Glasscheiben, durch eine Beschichtungsanlage, bei dem die Glasscheiben mittels einer Transportvorrichtung so durch die Anlage gefördert werden, dass eine ihrer Hauptflächen wenigstens teilweise durch einen Schutz gegen das aufzubringende Beschichtungsmaterial abgedeckt ist, **dadurch gekennzeichnet, dass** während des Beschichtungsvorganges zumindest ein Teil der abzudeckenden Hauptfläche im Kontakt mit einem flexiblen Gewebe gehalten wird, das an der Transportvorrichtung festgelegt ist und eine Ablagerung von Beschichtungsmaterial verhindert.

2. Verfahren nach Anspruch 1, **dadurch gekennzeichnet, dass** das Gewebe zur Erhöhung seiner Flexibilität mit einem Ausschnitt versehen wird, dessen Umriss,kleiner als der Umriss der kleinsten zu transportierenden starren Scheibe ist.

3. Verfahren nach Anspruch 1 oder 2, **dadurch gekennzeichnet, dass** der Kontakt zwischen den Scheiben und der Gewebefläche durch zusätzliche Mittel verbessert wird, um die vollflächige Auflage sicherzustellen.

4. Verfahren nach Anspruch 3, **dadurch gekennzeichnet, dass** der Kontakt der Scheiben mittels mechanischer, am äußeren Rand der Scheiben angreifender Spannvorrichtungen erhöht wird.

5. Verfahren nach Anspruch 3, **dadurch gekennzeichnet, dass** der Kontakt durch lokale Unterdruckbeaufschlagung von der Rückseite der Gewebefläche her verbessert wird.

6. Verfahren nach einem der vorstehenden Ansprüche, **dadurch gekennzeichnet, dass** die Scheiben liegend auf einer frei gespannten flexiblen Gewebefläche transportiert werden.

7. Verfahren nach einem der Ansprüche 3 bis 5, **dadurch gekennzeichnet, dass** die Scheiben in aufrechter Stellung transportiert werden.

8. Verfahren zum Beschichten von Glasscheiben, wobei die Glasscheiben durch eine Beschichtungsanlage mit dem Verfahren gemäß einem der vorstehenden Ansprüche transportiert werden.

9. Anlage zum Abscheiden einer Beschichtung auf einer der Flächen von Glasscheiben, mit einer Transportvorrichtung zum Transportieren von Glasscheiben durch die Beschichtungsanlage, welche Vorrichtung Mittel zum Abdecken zumindest eines Teils der anderen Fläche der Glasscheiben umfasst, um das Abscheiden von Beschichtungsmaterial auf der anderen Fläche zu verhindern, wobei das Mittel zum Abdecken ein flexibles Gewebe umfasst, das an der Transportvorrichtung so festgelegt ist, dass die besagte andere Fläche während eines Beschichtungsvorgangs zumindest teilweise in Kontakt mit dem Gewebe ist.

10. Anlage nach dem vorhergehenden Anspruch, **dadurch gekennzeichnet, dass** Mittel zum Spannen der Gewebefläche vorgesehen sind.

11. Anlage nach einem der beiden vorhergehenden Ansprüche, **dadurch gekennzeichnet, dass** das Gewebe der Transportvorrichtung über einen Kasten oder Rahmen gespannt ist, dessen Fläche vorzugsweise größer als die Fläche der größten zu transportierenden Scheibe ist.

12. Anlage nach einem der vorhergehenden Anlagenansprüche, **dadurch gekennzeichnet, dass** das Gewebe mit einem Ausschnitt versehen ist, dessen Umriss vorzugsweise kleiner als der Umriss der kleinsten zu transportierenden Scheibe ist.

13. Anlage nach einem der vorhergehenden Anlagenansprüche, **dadurch gekennzeichnet, dass** die Transportvorrichtung Mittel zum Verbessern der flächigen Berührung zwischen der abzudeckenden Scheibenfläche und der Gewebefläche umfasst.

14. Anlage nach dem vorhergehenden Anspruch, **dadurch gekennzeichnet, dass** die Mittel als mechanische, am äußeren Rand der Glasscheiben angreifende Spannvorrichtungen ausgeführt sind.

15. Anlage nach dem vorhergehenden Anspruch 13, **dadurch gekennzeichnet, dass** die Mittel als von der Rückseite der Gewebefläche her wirkende Sauger ausgeführt sind.

16. Verfahren zum Versehen von Glasscheiben mit einer Beschichtung, wobei die Glasscheiben durch die Anlage nach einem der vorhergehenden Anlagenansprüchen transportiert werden.
